(19) Europäisches Patentamt / European Patent Office / Office européen des brevets

(11) **EP 4 133 290 B1**

(12) **EUROPÄISCHE PATENTSCHRIFT**

(45) Veröffentlichungstag und Bekanntmachung des Hinweises auf die Patenterteilung:
**17.07.2024 Patentblatt 2024/29**

(21) Anmeldenummer: **21720168.0**

(22) Anmeldetag: **09.04.2021**

(51) Internationale Patentklassifikation (IPC):
**G01R 27/18** (2006.01)   **B60L 3/00** (2019.01)
**G01R 27/26** (2006.01)

(52) Gemeinsame Patentklassifikation (CPC):
**G01R 27/18; G01R 27/2605**

(86) Internationale Anmeldenummer:
**PCT/AT2021/060120**

(87) Internationale Veröffentlichungsnummer:
**WO 2021/203157 (14.10.2021 Gazette 2021/41)**

(54) **VERFAHREN, VORRICHTUNG UND SYSTEM ZUR BESTIMMUNG EINES KAPAZITÄTSWERTES EINER ERDUNGSKAPAZITÄT EINES UNGEERDETEN STROMNETZES**

METHOD, APPARATUS AND SYSTEM FOR DETERMINING A CAPACITANCE VALUE OF AN EARTHING CAPACITANCE OF AN UNEARTHED POWER SUPPLY SYSTEM

PROCÉDÉ, APPAREIL ET SYSTÈME POUR DÉTERMINER UNE VALEUR DE CAPACITÉ D'UNE CAPACITÉ DE MISE À LA TERRE D'UN SYSTÈME D'ALIMENTATION ÉLECTRIQUE NON MIS À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.04.2020 AT 503122020**

(43) Veröffentlichungstag der Anmeldung:
**15.02.2023 Patentblatt 2023/07**

(73) Patentinhaber: **Kristl, Seibt & Co. Gesellschaft M.B.H.**
**8052 Graz (AT)**

(72) Erfinder:
• **AUER, Christian**
**8020 Graz (AT)**

• **GÖLDNER, Arthur**
**9583 Faak am See (AT)**
• **HAIDINGER, Thomas**
**8075 Hart bei Graz (AT)**

(74) Vertreter: **SONN Patentanwälte GmbH & Co KG**
**Riemergasse 14**
**1010 Wien (AT)**

(56) Entgegenhaltungen:
EP-A1- 1 586 910          EP-B1- 1 586 910
DE-A1- 102012 019 094     DE-A1- 2 357 081
DE-A1- 2 618 303          DE-C3- 2 357 081

**Beschreibung**

Die Erfindung betrifft ein Verfahren zur Bestimmung eines Kapazitätswerts einer Erdungskapazität eines ungeerdeten Stromnetzes, bei dem zur Überwachung eines unvermeidbaren Isolationswiderstandes des Stromnetzes mit Hilfe einer Isolationsüberwachungseinrichtung eine periodische Spannung mit einer variablen, von der Erdungskapazität abhängigen Periodendauer an das Stromnetz gelegt wird.

Des Weiteren betrifft die Erfindung eine Vorrichtung zur Bestimmung eines Kapazitätswerts einer Erdungskapazität eines ungeerdeten Stromnetzes sowie ein System bestehend aus einem ungeerdeten Stromnetz, einer Isolationsüberwachungseinrichtung und einer Vorrichtung zur Bestimmung eines Kapazitätswerts einer Erdungskapazität des ungeerdeten Stromnetzes.

Im Unterschied zu geerdeten Stromnetzen sind ungeerdete Stromnetze gegenüber der Erde bzw. der Umgebung elektrisch isoliert. In der Regel werden ungeerdete Stromnetze galvanisch getrennt von einem Hauptnetz über einen ungeerdeten Transformator oder von einer unabhängigen Spannungsquelle, beispielsweise einer (Hochvolt-)Batterie, gespeist. Beispiele für ungeerdete Stromnetze sind IT-Netze in Gebäuden (franz. Isolé Terre) oder von (Hochvolt-)Batterien gespeiste Netze in Elektrofahrzeugen.

Die Isolierung des ungeerdeten Stromnetzes weist jedoch einen unvermeidbaren ohmschen Isolationswiderstand zur Erde bzw. Umgebung auf. Um diesen Isolationswiderstand zu überwachen um dadurch Fehler im Stromnetz erkennen zu können, können Isolationsüberwachungseinrichtungen, auch Isolationswächter genannt, an das ungeerdete Stromnetz angeschlossen sein. Diese Einrichtungen schalten meist abwechselnd eine positive und eine negative elektrische Spannung an das ungeerdete Stromnetz und messen den sich in der Folge einstellenden elektrischen Strom, der über den Isolationswiderstand fließt. Aus dem gemessenen Strom und der Höhe der angelegten Spannung kann der Isolationswiderstand berechnet werden. Allerdings kann der zur Bestimmung des Isolationswiderstandes heranzuziehende Strom nicht unmittelbar nach dem Auf- oder Umschalten der Spannung gemessen werden, da zunächst Umlade- und Einschwingvorgänge, die auf die Erdungskapazität zurückzuführen sind, abgewartet werden müssen. Da die Dauer der Umlade- und Einschwingvorgänge von der Erdungskapazität des Stromnetzes abhängig ist und daher, je nach Kapazitätswert, variieren kann, müsste bei den Messungen des Stromes zur Bestimmung des Isolationswiderstandes stets von den ungünstigsten Rahmenbedingungen und daher von einer Höchstdauer der Umlade- und Einschwingvorgänge ausgegangen werden. Um die Dauer bis zur Messung zu verkürzen, kann daher vorgesehen sein, die Zeit zwischen einem Spannungssprung und der Messung des Stromes adaptiv, abhängig vom Strom- bzw. Spannungsverlauf, an das Einschwingverhalten anzupassen. Sobald sich der Strom in Folge des Aufschaltens einer Spannung durch die Isolationsüberwachungseinrichtung nur mehr geringfügig ändert und seinen Endwert quasi erreicht hat, kann dieser gemessen und zur Bestimmung des Isolationswiderstandes herangezogen werden. Anschließend kann die Spannung wieder umgeschaltet werden. Diese Vorgangsweise ist beispielsweise in EP 0 654 673 B1 beschrieben.

Bei der Bestimmung des Isolationswiderstandes stellt die Erdungskapazität somit einen Störfaktor dar. Bei vielen Anwendungen ist die Erdungskapazität jedoch grundsätzlich erwünscht oder sogar notwendig, beispielsweise um hochfrequente Störungen zu unterdrücken. Es wäre daher bei diesen Anwendungen wünschenswert, den Kapazitätswert der Erdungskapazität bestimmen zu können.

Aus dem Stand der Technik, beispielsweise aus der WO 2011/160881 A1, der EP 3 579 002 A1, der DE 10 2018 117 296 A1 und der EP 2 256 506 B1, sind bereits mehrere Verfahren und Einrichtungen bekannt, mit denen der Kapazitätswert einer Erdungskapazität bestimmt werden kann. In WO 2011/160881 A1 wird beispielsweise ein Gleichungssystem gelöst, welches einen Isolationswiderstand, eine Netzableitkapazität und eine Netzinduktivität als Unbekannte enthält. In EP 3 579 002 A1 wird eine spezielle Impulsfolge aufgeschaltet und der Isolationswiderstand bzw. die Kapazität ermittelt. In DE 10 2018 117 296 A1 werden Verlagerungsspannungen gemessen und Aufteilungsfaktoren bestimmt, um die Kapazitäten der einzelnen Leiter zu ermitteln. In EP 2 256 506 B1 wird eine Impedanz bestimmt und daraus eine Ableitkapazität ermittelt. Weitere Verfahren und Vorrichtungen zur Isolationsüberwachung sind aus DE 26 18 303 A1, DE 23 57 081 A1, DE 10 2012 019 094 A1 und EP 1 586 910 A1 bekannt.

All diese Verfahren sind vergleichsweise kompliziert, aufwendig und mitunter auch fehleranfällig. Zudem sind die Verfahren aus dem Stand der Technik meist in der Isolationsüberwachungseinrichtung oder in einer anderen Messeinrichtung integriert und daher "von außen" durch Dritte nicht zugänglich, da Isolationsüberwachungseinrichtungen und andere Messeinrichtungen oftmals gar keine oder nur herstellerspezifische Schnittstellen zum Auslesen aufweisen. Vielfach ist es jedoch notwendig, den Kapazitätswert einer Erdungskapazität rasch "von außen", d. h. ohne aufwendige Umbauarbeiten, zu bestimmen. Dies kann zum Beispiel der Fall sein, wenn ein Elektrofahrzeug oder eine Ladestation für Elektrofahrzeuge, die oftmals als ungeerdete Stromnetze ausgeführt sind, im Rahmen einer regelmäßig stattfindenden Überprüfung untersucht werden sollen.

Es ist daher Aufgabe, die Nachteile des Standes der Technik zumindest teilweise zu lindern bzw. gänzlich zu beseitigen. Insbesondere ist es Aufgabe der Erfindung, eine rasche und unkomplizierte Bestimmung des Kapazitätswerts einer Erdungskapazität eines ungeerdeten Stromnetzes zu ermöglichen.

Gelöst wird diese Aufgabe mit einem Verfahren gemäß Anspruch 1. Erfindungsgemäß ist bei einem Verfahren der eingangs erwähnten Art vorgesehen, dass eine Messkapazität mit einem bekannten Kapazitätswert an das Stromnetz elektrisch zugeschaltet wird und der Kapazitätswert der Erdungskapazität auf Basis einer sich in Folge der Zuschaltung der Messkapazität einstellenden Änderung der Periodendauer oder einer dazu proportionalen zeitlichen Größe ermittelt wird. Vorteilhafterweise kann mit dem erfindungsgemäßen Verfahren der Kapazitätswert einer Erdungskapazität eines ungeerdeten Stromnetzes bestimmt werden, ohne aufwendige Umbaumaßnahmen am Stromnetz oder anderen Einrichtungen, wie etwa der Isolationsüberwachungseinrichtung, vornehmen zu müssen. Es kann insbesondere vermieden werden, die Isolationsüberwachungseinrichtung zu entfernen und eine direkte Kapazitätsmessung am Stromnetz durchzuführen oder die Isolationsüberwachungseinrichtung durch eine andere Einrichtung zur Kapazitätsbestimmung zu ersetzen. Es ist auch nicht notwendig, einen möglicherweise bereits durch die Isolationsüberwachungseinrichtung bestimmten Kapazitätswert auszulesen, was auf Grund der oftmals verwendeten proprietären oder nicht vorhandenen Schnittstellen gar nicht möglich ist. Mit anderen Worten ist es mit dem erfindungsgemäßen Verfahren möglich, trotz und sogar mit Hilfe einer an das Stromnetz angeschlossenen Isolationsüberwachungseinrichtung eine rasche und unkomplizierte Kapazitätsmessung durchzuführen. Damit ist eine Bestimmung des Kapazitätswerts der Erdungskapazität "von außen" möglich. Dies ist insbesondere bei der Überprüfung von Ladestationen für Elektrofahrzeugen oder von Stromnetzen von Elektrofahrzeugen von Vorteil. Die Isolationsüberwachungseinrichtung schaltet eine periodische Spannung mit einer insbesondere variablen Periodendauer an das Stromnetz. Die periodische Spannung kann eine Wechselspannung beliebiger Form sein. Vorzugsweise ist die periodische Spannung im Wesentlichen eine Rechteckspannung, insbesondere eine Rechteckwechselspannung. Die periodische Spannung kann auch einen Gleichanteil aufweisen. Wie weiter oben erwähnt, wird nach Abklingen der Umlade- und Einschwingvorgänge der sich einstellende Strom gemessen und auf Basis dieses Stroms und der von der Isolationsüberwachungseinrichtung angelegten Spannung der Isolationswiderstand des Stromnetzes bestimmt. Nach der Strommessung wird die periodische Spannung von der Isolationsüberwachungseinrichtung umgeschaltet, also beispielsweise von einem positiven auf einen negativen Spannungswert geschaltet. Die Periodendauer der periodischen Spannung ist variabel und an die Dauer der Umlade- bzw. Einschwingvorgänge angepasst. Das bedeutet, dass die Periodendauer zumindest der Dauer entspricht, bis die Umlade- bzw. Einschwingvorgänge unterhalb eines Schwellwertes abgeklungen sind und sich der Strom nicht mehr oder nur mehr minimal ändert. Die Periodendauer kann adaptiv an die Dauer der auf die Erdungskapazität zurückzuführenden kapazitiven Umlade- bzw. Einschwingvorgänge angepasst werden, wie dies beispielsweise in EP 0 654 673 B1 beschrieben wird. Das ungeerdete Stromnetz kann beispielsweise ein IT-Stromnetz (franz. Isolé Terre), ein mit einer (Hochvolt-)Batterie gespeistes Stromnetz eines Elektrofahrzeuges oder eine Ladestation für ein Elektrofahrzeug sein. Das Stromnetz kann als Wechsel- und/oder Gleichstromnetz ausgebildet sein. Der Begriff "Stromnetz" bezeichnet in dieser Offenbarung ein elektrisches Energienetz, das mittels Spannungs- oder Stromquelle gespeist wird. Ungeerdete Stromnetze besitzen keine elektrische Verbindung mit der Erde oder der Umgebung, sondern sind gegenüber der Erde bzw. der Umgebung elektrisch isoliert. Zwischen Stromnetz und Erde besteht demnach keine galvanische Verbindung. Die Isolierung ist jedoch nicht ideal und wird durch den unvermeidbaren Isolationswiderstand repräsentiert, der im fehlerfreien Fall vorzugsweise einen Wert von mehreren hundert Kiloohm aufweist. Bei Elektrofahrzeugen wird unter Erde bzw. Erdung die elektrische Masse des Fahrzeugs verstanden. Diese kann zum Beispiel durch die elektrisch leitfähige Karosserie gebildet sein. Verbraucher in Fahrzeugen sind meist mit der Fahrzeugkarosserie elektrisch verbunden. Die elektrische Isolierung des Stromnetzes wird durch den unvermeidbaren Isolationswiderstand repräsentiert, der von der Isolationsüberwachungseinrichtung überwacht wird. Vorzugsweise weist der Isolationswiderstand im fehlerfreien Zustand einen Wert von zumindest 100 k2 auf. Durch das Zuschalten der Messkapazität an das Stromnetz, vorzugsweise parallel zur Erdungskapazität, wird der Zustand des Stromnetzes aus Sicht der Isolationsüberwachungseinrichtung verändert. Die Messkapazität wird vorzugsweise, gegebenenfalls mit weiteren elektrischen Bauelementen, elektrisch zwischen Stromnetz und Erde geschaltet. Die Zuschaltung erfolgt vorzugsweise mit Hilfe zumindest eines elektrischen Schalters. Durch das Zuschalten der Messkapazität wird die aus Sicht der Isolationsüberwachungseinrichtung sichtbare elektrische Kapazität vergrö-ßert, wodurch sich auch die Dauer der Umlade- bzw. Einschwingvorgängen und damit die Periodendauer der periodischen Spannung verlängert. Auf Basis dieser Änderungen kann auf die Erdungskapazität des Stromnetzes (d.h. ohne zugeschaltete Messkapazität) geschlossen werden. Zu diesem Zweck kann die Änderung der Periodendauer der periodischen Spannung oder eine dazu proportionale Größe herangezogen werden. Eine zur Periodendauer proportionale zeitliche Größe kann beispielsweise die halbe Periodendauer (also die Zeit zwischen den Nulldurchgängen der Spannung) oder die ohmsch-kapazitive Ladezeitkonstante der Umlade- bzw. Einschwingvorgängen sein.

Um die Periodendauer der von der Isolationsüberwachungseinrichtung angelegten periodischen Spannung oder eine dazu proportionale Größe zu bestimmen, ist in einer bevorzugten Ausführungsform vorgesehen, dass zumindest eine elektrische Messeinrichtung, insbesondere eine Spannungsmesseinrichtung elektrisch parallel zur Messkapazität, elektrisch an das Stromnetz angeschlossen ist und auf Basis eines Verlaufs einer gemessenen elektrischen Größe, insbesondere eines gemessenen Spannungsverlaufs, die Periodendauer der periodischen Spannung oder die dazu proportionale Größe ermittelt wird. Mit Hilfe der elektrischen Messeinrichtung kann die periodische Spannung direkt oder indirekt gemessen und aus deren Verlauf die Periodendauer oder eine dazu proportionale zeitliche Größe bestimmt werden. Die Periodendauer oder die dazu proportionale zeitliche Größe kann beispielsweise aus den Nulldurchgängen eines Spannungsverlaufs oder auf Basis einer Analyse des Signalspektrums ermittelt werden. Die Messeinrichtung ist vorzugsweise zwischen Stromnetz und Erde geschaltet.

In einer bevorzugten Ausführungsform weist das Verfahren die folgenden Schritte auf:

- Bestimmen einer ersten Periodendauer oder einer dazu proportionalen ersten zeitlichen Größe;
- Elektrisches Zuschalten der Messkapazität an das Stromnetz;
- Bestimmen einer zweiten Periodendauer oder einer dazu proportionalen zweiten zeitlichen Größe nach dem Zuschalten der Messkapazität;
- Ermitteln des Kapazitätswerts der Erdungskapazität auf Basis der ersten und zweiten Periodendauer oder der dazu proportionalen ersten und zweiten zeitlichen Größe.

In einer besonders bevorzugten Ausführungsform werden die Schritte in der angegebenen Reihenfolge ausgeführt. Hierbei wird zunächst ohne zugeschaltete Messkapazität die erste Periodendauer der von der Isolationsüberwachungseinrichtung aufgeschalteten periodischen Spannung oder eine dazu proportionale erste zeitliche Größe bestimmt. Anschließend wird die Messkapazität elektrisch an das Stromnetz geschaltet, wodurch sich die Umlade- und Einschwingvorgänge und folglich auch die Periodendauer der periodischen Spannung verlängern. Anschließend wird die verlängerte zweite Periodendauer oder eine dazu proportionale zweite zeitliche Größe bestimmt. Auf Basis der ersten und zweiten Periodendauer oder der ersten und zweiten zeitlichen Größe wird in weiterer Folge der Kapazitätswert der Erdungskapazität bestimmt. Zu diesem Zweck kann beispielsweise eine Berechnung ausgeführt werden. Alternativ kann das Ergebnis in Abhängigkeit der ersten und zweiten Periodendauer bzw. ersten und zweiten zeitlichen Größe in einer Tabelle gespeichert sein und ausgelesen werden.

In einer bevorzugten Ausführungsform wird der Kapazitätswert gemäß der Berechnungsvorschrift

$$C_E' = \frac{X_1}{X_2 - X_1} C_M' \qquad (1)$$

berechnet, wobei $C_M'$ der Kapazitätswert der Messkapazität in Farad (oder Teile davon, wie $\mu$F) und $C_E'$ der Kapazitätswert der zu berechnenden Erdungskapazität in Farad (oder Teile davon, wie $\mu$F) bedeutet. $X_1$ kann der ersten Periodendauer und $X_2$ der zweiten Periodendauer entsprechen. Alternativ kann $X_1$ auch der zur ersten Periodendauer proportionalen ersten zeitlichen Größe und $X_2$ der zur zweiten Periodendauer proportionalen zweiten zeitlichen Größe entsprechen. Beispielsweise kann es sich bei der ersten zeitlichen Größe um die halbe erste Periodendauer und bei der zweiten zeitlichen Größe um die halbe zweite Periodendauer handeln. Es kann sich bei der ersten zeitlichen Größe auch um die ohmsch-kapazitive Ladezeitkonstante des Stromnetzes ohne Messkapazität und bei der zweiten zeitlichen Größe um die ohmsch-kapazitive Ladezeitkonstante des Stromnetzes mit zugeschalteter Messkapazität handeln.

Da ein Stromnetz typischerweise mehrere elektrische Leiter aufweist, ist es günstig, wenn die Messkapazität mehrere Teilmesskapazitäten mit vorzugsweise jeweils im Wesentlichen gleich gro-ßen Kapazitätswerten aufweist, wobei an zumindest zwei, vorzugsweise an jeden Leiter des Stromnetzes jeweils eine Teilmesskapazität elektrisch zugeschaltet wird. Die Zuschaltung der Teilmesskapazitäten kann individuell über elektrische Schalter erfolgen. Im zugeschalteten Zustand sind die Teilmesskapazitäten vorzugsweise elektrisch zwischen Erde und Leiter geschaltet. Vorzugsweise werden die Teilmesskapazitäten aus der Sicht der Erdungskapazität parallel zu dieser geschaltet.

Die eingangs gestellte Aufgabe wird auch durch eine Vorrichtung zur Bestimmung eines Kapazitätswerts einer Erdungskapazität eines ungeerdeten Stromnetzes gelöst, an welches eine Isolationsüberwachungseinrichtung angeschlossen ist. Die Isolationsüberwachungseinrichtung ist dazu eingerichtet, zur Überwachung eines Isolationswiderstandes des Stromnetzes eine periodische Spannung mit einer variablen, von der Erdungskapazität abhängigen Periodendauer an das Stromnetz zu schalten. Die Vorrichtung kann eine eigenständige Einheit bilden und elektrisch mit dem Stromnetz verbunden werden. Die Vorrichtung weist eine Messkapazität mit einem bekannten Kapazitätswert auf. Erfindungsgemäß weist die Vorrichtung auf:

- eine Berechnungseinheit, die dazu eingerichtet ist, im elektrisch an das Stromnetz angeschlossenen Zustand die Periodendauer der periodischen Spannung oder eine dazu proportionale Größe zu ermitteln und den Kapazitätswert der Erdungskapazität auf Basis einer sich in Folge einer Zuschaltung der Messkapazität an das Stromnetz einstellenden Änderung der Periodendauer oder der dazu proportionalen zeitlichen Größe zu ermitteln.

Die Vorrichtung ist in einem an das Stromnetz angeschlossenen Zustand in der Lage, das oben beschriebene Verfahren auszuführen und somit die Erdungskapazität des Stromnetzes zu bestimmen. Aus diesem Grund wird hinsichtlich der Vorteile und Merkmale auf das oben beschrieben Verfahren verwiesen. Die Ermittlung der Periodendauer bzw. der proportionalen zeitlichen Größe kann aus einer direkten oder indirekten Messung der von der Isolationsüberwachungseinrichtung aufgeschalteten periodischen Spannung erfolgen. Die Vorrichtung kann ein Gehäuse aufweisen, innerhalb dessen die Messkapazität, die Berechnungseinheit und gegebenenfalls eine Messeinrichtung zur Bestimmung der Periodendauer der periodischen Spannung oder eine dazu proportionale Größe angeordnet sein können. Die Vorrichtung kann zumindest einen elektrischen Anschluss zur Verbindung mit dem Stromnetz aufweisen. Die Messkapazität kann über diesen Anschluss mit dem Stromnetz verbunden werden. Zur Verbindung mit mehreren Leitern des Stromnetzes können auch mehrere solcher Anschlüsse vorgesehen sein. Die Vorrichtung kann weiters einen Erdungsanschluss aufweisen. Die Messkapazität kann über diesen Anschluss mit der Erde verbunden sein. Die Berechnungseinheit kann ein Mikroprozessor sein. Insbesondere kann die Berechnungseinheit durch eine SPS (Speicherprogrammierbare Steuerung) gebildet sein.

In einer bevorzugten Ausführungsform ist vorgesehen, dass die Messkapazität zumindest zwei Teilmesskapazitäten, insbesondere Kondensatoren, mit vorzugsweise jeweils im Wesentlichen gleich großen Kapazitätswerten aufweist. Die Teilmesskapazitäten können jeweils mit einem eigenen elektrischen Anschluss der Vorrichtung verbindbar sein, beispielsweise über einen Schalter. Jeder Anschluss kann zur Verbindung mit einem Leiter des Stromnetzes eingerichtet sein. Die Teilmesskapazitäten können dadurch jeweils an unterschiedliche Leiter des Stromnetzes angeschlossen werden.

Vorzugsweise weist die Vorrichtung einen Erdungsanschluss und zumindest zwei elektrische Anschlüsse zur elektrischen Verbindung mit dem Stromnetz auf, wobei mit jedem Anschluss jeweils eine Teilmesskapazität, vorzugsweise über einen Schalter, elektrisch verbindbar ist. Die Anschlüsse sind mit Leitern des Stromnetzes elektrisch verbindbar. Die Anschlüsse können als Stecker oder Klemmen ausgebildet sein.

Um die Periodendauer der periodischen Spannung oder die proportionale zeitliche Größe zu bestimmen, kann zumindest eine elektrische Messeinrichtung, insbesondere eine Spannungsmesseinrichtung elektrisch parallel zur Messkapazität, vorgesehen sein und die Berechnungseinheit dazu eingerichtet sein, auf Basis eines durch die Messeinrichtung gemessenen Verlaufs einer elektrischen Größe, insbesondere eines gemessenen Spannungsverlaufs, die Periodendauer oder die dazu proportionale zeitliche Größe zu ermitteln. Die Messeinrichtung kann innerhalb des Gehäuses der Vorrichtung angeordnet sein. Vorzugsweise ist die Messeinrichtung zwischen Erde und Stromnetz angeordnet.

Die Aufgabe wird auch durch ein System gelöst, wobei das System die folgenden Bestandteile aufweist:

- ein ungeerdetes Stromnetz, insbesondere eine elektrischen Ladestation für Elektrofahrzeuge oder ein Batterienetz eines Fahrzeugs, wobei das Stromnetz eine Erdungskapazität und einen Isolationswiderstand aufweist;
- ein an das Stromnetz elektrisch angeschlossenen Isolationsüberwachungseinrichtung, die dazu eingerichtet ist, zur Überwachung des Isolationswiderstandes des Stromnetzes eine periodische Spannung mit einer variablen, von der Erdungskapazität abhängigen Periodendauer an das Stromnetz zu schalten;
- eine Vorrichtung der oben beschriebenen Art, welche an das Stromnetz anschließbar ist.

Im Folgenden wird die Erfindung an Hand von Figuren näher erläutert, auf die sie allerdings nicht beschränkt sein soll. Es zeigen:

Fig. 1 ein Schaltbild eines ungeerdeten Stromnetzes, an welches eine Isolationsüberwachungseinrichtung angeschlossen ist;

Fig. 2 einen Verlauf einer elektrischen Spannung zwischen Stromnetz und Erde;

Fig. 3 das Schaltbild von Fig. 1, wobei eine Vorrichtung zur Bestimmung der Erdungskapazität an das Stromnetz angeschlossen ist;

Fig. 4 einen geänderten Verlauf der elektrischen Spannung von Fig. 2; und

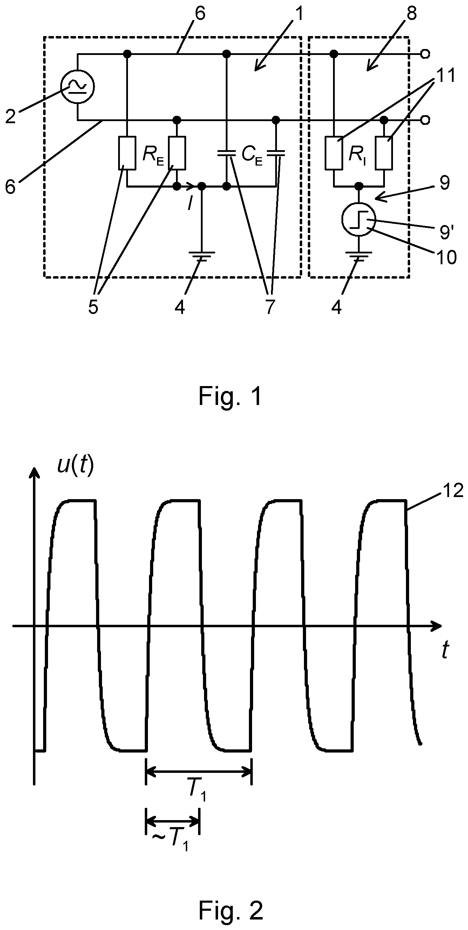

Fig. 1 zeigt ein vereinfachtes Schaltbild eines ungeerdeten Stromnetzes 1, welches von einer Gleich- und/oder Wechselspannungsquelle 2 gespeist wird. Allfällige Leitungsinduktivitäten und Leitungswiderstände werden vernachlässigt. Bei dem Stromnetz 1 kann es sich beispielsweise um eine Ladestation für ein Elektrofahrzeug handeln. Das Stromnetz 1 ist vollständig gegenüber der Erde 4 bzw. Umgebung isoliert. Die Isolierung des Stromnetzes 1 zur Erde 4 wird durch einen von zwei Teilwiderständen 5 repräsentierten ohmschen Isolationswiderstand $R_E$ dargestellt, der im fehlerfreien Zustand einen Wert von zumindest 100 k$\Omega$, vorzugsweise mehr als 200 k$\Omega$, besitzt. Jeder Teilwiderstand 5 ist mit einem Leiter 6 des Stromnetzes 1 verbunden. Neben dem Isolationswiderstand $R_E$ weist das Stromnetz 1 gegenüber der Erde 4 eine Erdungskapazität $C_E$ auf, die in dem gezeigten Schaltbild durch zwei Teilkapazitäten 7 repräsentiert wird, die ebenfalls jeweils mit einem Leiter 6 des Stromnetzes 1 verbunden sind.

Um die Isolierung des Stromnetzes 1 zur Erde 4 zu überwachen und um dadurch allfällige Fehler zu erkennen, ist an das Stromnetz 1 eine Isolationsüberwachungseinrichtung 8 elektrisch angeschlossen. Diese verfügt über eine Spannungsquelle 9 und ist dazu eingerichtet, eine periodische Spannung 10, vorzugsweise eine Rechteckspannung, mit einer Periodendauer T an das Stromnetz 1 anzulegen. In dem Schaltbild von Fig. 1 ist die Spannungsquelle 9 als idealisierte Spannungsquelle 9' mit einem Innenwiderstand $R_I$ dargestellt, wobei der Innenwiderstand durch zwei Teilwiderstände 11 gebildet ist. Je ein Teilwiderstand 11 ist mit einem Leiter 6 verbunden. Die Isolationsüberwachungseinrichtung 8 ist derart mit dem Stromnetz 1 verbunden, dass die Spannungsquelle 9 die periodische Spannung 10 an die beiden Leiter 6 anlegen kann.

In der gesamten Offenbarung werden Werte von elektronischen Bauelementen mit gestrichenen Bezeichnungen dargestellt.

Der Widerstandswert $R_E$' des Isolationswiderstand $R_E$ kann aus der Höhe der aufgeschalteten Spannung 10 und dem sich einstellenden Strom I über den Isolationswiderstand $R_E$ berechnet werden. Allerdings kann der Strom I nicht unmittelbar nach dem Aufschalten bzw. Umschalten der periodischen Spannung 10 gemessen und zur Berechnung des Widerstandswerts $R_E$' herangezogen werden, da zunächst sämtliche auf die Erdungskapazität $C_E$ zurückzuführenden Umlade- und Einschwingvorgänge abgewartet werden müssen. Die Umlade- und Einschwingvorgänge sind im Wesentlichen auf das Zusammenwirken ohmscher Widerstände, vorwiegend dem Isolationswiderstand $R_E$ und dem Innenwiderstand $R_I$ der Spannungsquelle 9, und der Erdungskapazität $C_E$ zurückzuführen. Die Ladezeitkonstante ohmsch-kapazitiver elektrische Netzwerke berechnet sich im Allgemeinen zu $\tau=R'C'$, wobei R' ein allgemeiner ohmscher Widerstandswert in Ohm und C' ein allgemeiner Kapazitätswert in Farad ist. Typischerweise folgt die Ladekurve eines Kondensators in einem ohmsch-kapazitiven Netzwerk einem Verlauf, der im Wesentlichen proportional zu $1-e^{-t/\tau}$ ist, wobei e die Eulersche Zahl und t die Zeit ist. Für das in Fig. 1 dargestellte Schaltbild berechnet sich die Ladezeitkonstante $\tau$, im Folgenden als $\tau_1$ bezeichnet, zu

$$\tau_1 = (R_E' \vee R_I')C_E' = \frac{R_E' R_I'}{R_E'+R_I'}C_E'. \qquad (2)$$

Die Umlade- und Einschwingvorgänge sind in Fig. 2 vereinfacht dargestellt. Es wird angenommen, dass die periodische Spannung 10 eine ideale Rechteckspannung ist. In Fig. 2 ist ein zeitlicher Verlauf 12 der Spannung des Stromnetzes 1 gegen Erde 4 dargestellt, die über der Erdungskapazität $C_E$ bzw. dem Isolationswiderstand $R_E$ abfällt. Auf der Abszisse ist die Zeit t und auf der Ordinate ist die Spannung u(t) aufgetragen. Es ist erkennbar, dass der Spannungsverlauf 12 einen charakteristischen exponentiell einschwingenden Verlauf ähnlich einer Kondensator-Ladekurve besitzt. Erst wenn die Umlade- und Einschwingvorgänge abgeklungen sind, kann der Strom I zur Berechnung des Widerstandswert $R_E$' des Isolationswiderstandes $R_E$ herangezogen werden, da sich dann der Strom nicht mehr wesentlich ändert.

Da die Dauer der Umlade- und Einschwingvorgänge maßgeblich vom Kapazitätswert $C_E$' der Erdungskapazität $C_E$ abhängig ist, kann die Wartezeit, bis ein Stromwert zur Bestimmung des Widerstandswert $R_E$' des Isolationswiderstandes $R_E$ verwendet werden kann, mitunter beträchtlich variieren. Es müsste bei der Bestimmung des Widerstandswerts $R_E$' von den ungünstigsten Rahmenbedingungen ausgegangen werden und bis zur Messung des Stromes I eine maximal zu erwartende Zeitdauer abgewartet werden. Um die Zeitdauer zu minimieren, kann die Periodendauer T der periodischen Spannung 10 adaptiv an die Umlade- und Einschwingvorgänge angepasst werden. Zu diesem Zweck wird die Ladekurve des Stromes bzw. der Spannung gemessen und ein Stromwert zur Berechnung des Isolationswiderstandes $R_E$ herangezogen, sobald die Umlade- und Einschwingvorgänge im Wesentlichen abgeklungen sind. Sobald der Strom I gemessen wurde (oder eine bestimmte Zeit danach), kann die Spannung umgeschaltet werden. Dieser Vorgang wird von der Isolationsüberwachungseinrichtung 8 durchgeführt. Durch das Umschalten kommt die Periodizität der Spannung 10 zustande. Je länger die Umlade- und Einschwingvorgänge dauern, desto länger ist auch die Periodendauer T. Die Periodendauer T der periodischen Spannung 10 ist an die von den ohmschen Widerständen und der Erdungskapazität $C_E$ abhängigen Ladezeitkonstante $\tau$ gebunden und zu dieser proportional. Für die Periodendauer T der periodischen Spannung 10 des Stromnetzes 1 aus Fig. 1, im Folgenden als erste Periodendauer $T_1$ bezeichnet, gilt daher $\tau_1 \sim T_1$ bzw. $T_1 = k*\tau_1$, wobei k ein Proportionalitätsfaktor ist.

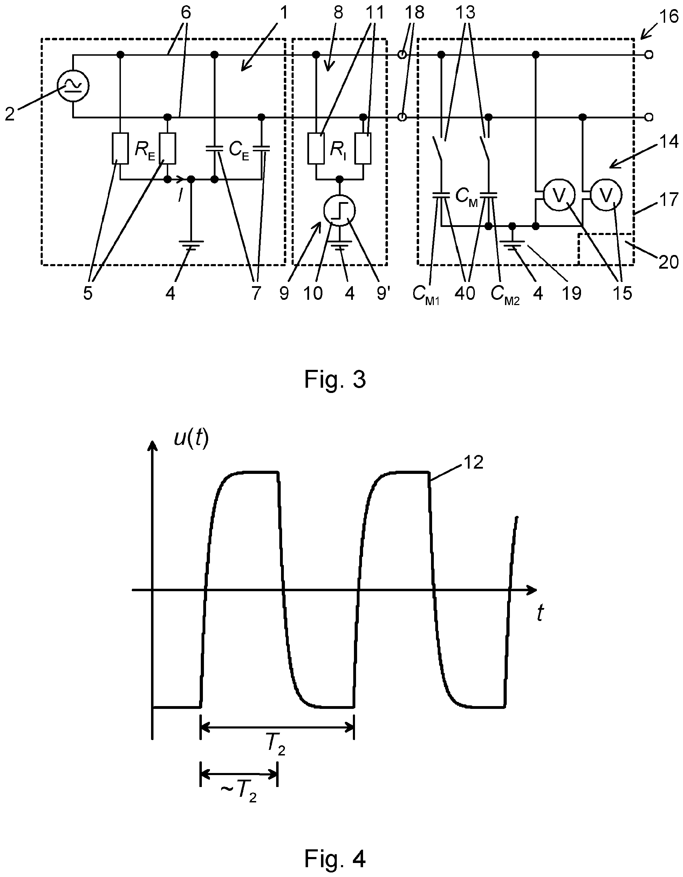

Mit Hilfe der Isolationsüberwachungseinrichtung 8 kann lediglich der Widerstandswert $R_E$' des Isolationswiderstand $R_E$ bestimmt werden. Bei vielen Anwendungen ist es jedoch wünschenswert, auch den Kapazitätswert $C_E$' der Erdungskapazität $C_E$ zu bestimmen. Zu diesem Zweck ist erfindungsgemäß vorgesehen, eine Messkapazität $C_M$ mit einem bekannten Kapazitätswert $C_M$' an das Stromnetz 1 zu schalten und auf Basis der stattfindenden Änderungen auf den Kapazitätswert $C_E$' der Erdungskapazität $C_E$ zu schließen. Dabei kann die Messkapazität $C_M$ auch an die Isolationsüberwachungseinrichtung 8 geschaltet werden, sofern eine elektrische Verbindung der Messkapazität mit dem Stromnetz 1 gewährleistet ist. Dies ist in Fig. 3 dargestellt. In der gezeigten Ausführungsform besitzt die Messkapazität $C_M$ zwei Teilmesskapazitäten $C_{M1}$ und $C_{M2}$ in Form von Kondensatoren 40, die jeweils über einen Schalter 13 mit einem Leiter 6 des Stromnetzes 1 elektrisch verbindbar sind. Es gilt $C_M' = C_{M1}' + C_{M2}'$. Die Messkapazität $C_M$ bzw. die zwei Teilmesskapazitäten $C_{M1}$ und $C_{M2}$ sind zwischen Erde 4 und Stromnetz 1 geschaltet. Elektrisch betrachtet ist die Messkapazität $C_M$ parallel zur Erdungskapazität $C_E$ geschaltet, wodurch bei der Berechnung der Gesamtkapazität die Kapazitätswerte $C_E'$ und $C_M'$ der Einzelkapazitäten $C_E$ und $C_M$ addiert werden. Durch das Zuschalten der Messkapazität $C_M$ wird daher die von der Isolationsmesseinrichtung 8 sichtbare Kapazität erhöht und dadurch die Ladezeitkonstante zu $\tau_2$ verlängert. $\tau_2$ berechnet sich mit zugeschalteter Messkapazität $C_M$ zu

$$\tau_2 = (R_E' \vee R_I')(C_E' + C_M') = \frac{R_E' R_I'}{R_E' + R_I'}(C_E' + C_M').\qquad(3)$$

Durch die verlängerte Ladezeitkonstante $\tau_2$ werden die Umlade- und Einschwingvorgänge und damit auch die Periodendauer T der periodischen Spannung 10 verlängert. Die verlängerte Periodendauer wird als zweite Periodendauer $T_2$ bezeichnet. Es gilt wiederum $\tau_2 \sim T_2$ bzw. $T_2 = k^*\tau_2$, wobei k der obengenannte Proportionalitätsfaktor ist. Die Verlängerung der Periodendauer T zur zweiten Periodendauer $T_2$ ist in Fig. 4 dargestellt.

Das erfindungsgemäße Verfahren sieht nun vor, durch Zuschaltung der Messkapazität $C_M$ die Ladezeitkonstante $\tau_1$ bzw. die erste Periodendauer $T_1$ der periodischen Spannung 10 der Isolationsüberwachungseinrichtung 8 zu verlängern und auf Basis dieser Änderung den Kapazitätswert $C_E'$ der Erdungskapazität $C_E$ zu bestimmen.

Es gilt:

$$T_1 = k\,\frac{R_E' R_I'}{R_E' + R_I'}\,C_E'\qquad(4)$$

sowie

$$T_2 = k\,\frac{R_E' R_I'}{R_E' + R_I'}(C_E' + C_M')\qquad(5)$$

Werden die Periodendauern $T_1$ und $T_2$ in Verhältnis gesetzt, so ergibt sich

$$\frac{T_2}{T_1} = \frac{C_E' + C_M'}{C_E'}.\qquad(6)$$

Durch Umformung erhält man

$$C_E' = \frac{T_1}{T_2 - T_1}\,C_M'.\qquad(7)$$

Aus der Kenntnis der ersten $T_1$ und zweiten Periodendauer $T_2$ sowie des Kapazitätswerts $C_M'$ der Messkapazität $C_M$ lässt sich somit der Kapazitätswert $C_E'$ der Erdungskapazität $C_E$ bestimmen.

An Stelle der Periodendauern $T_1$ und $T_2$ können auch zu den Periodendauern $T_1$ und $T_2$ proportionale Größen verwendet werden. Diese können als erste zeitliche Größe $\sim T_1$ und zweite zeitliche Größe $\sim T_2$ bezeichnet werden. Als erste zeitliche Größe $\sim T_1$ und zweite zeitliche Größe $\sim T_2$ können beispielsweise die halben Periodendauern (siehe Fig. 2 und Fig. 4) oder die Ladezeitkonstanten $\tau_2$ und $\tau_1$ selbst fungieren. Mit den Ladezeitkonstanten $\tau_2$ und $\tau_2$ würde Gleichung (7) lauten

$$C_E' = \frac{\tau_1}{\tau_2 - \tau_1}\,C_M'.\qquad(8)$$

Allgemeiner kann die Berechnungsvorschrift zur Bestimmung des Kapazitätswerts der Erdungskapazität daher wie in Gleichung (1) formuliert werden:

$$C_E' = \frac{X_1}{X_2 - X_1}\,C_M'.\qquad(1)$$

$X_1$ kann der ersten Periodendauer $T_1$ und $X_2$ der zweiten Periodendauer $T_2$ entsprechen. Alternativ kann $X_1$ der zur ersten Periodendauer proportionalen ersten zeitlichen Größe $\sim T_1$ und $X_2$ der zur zweiten Periodendauer proportionalen zweiten zeitlichen Größe $\sim T_2$ entsprechen.

Um die Periodendauer T der periodischen Spannung 10 oder eine dazu proportionale Größe $\sim$T zu bestimmen, kann eine Messeinrichtung 14 vorgesehen sein, die dazu eingerichtet ist, die periodische Spannung 10 direkt oder indirekt zu messen. Auf Basis der von der Messeinrichtung 14 durchgeführten Messung kann die Periodendauer T oder eine dazu proportionale Größe $\sim$T bestimmt werden. In der gezeigten Ausführungsform weist die Messeinrichtung 14 zwei Spannungsmesseinrichtungen 15 auf, die jeweils mit einem Leiter 6 des Stromnetzes 1 elektrisch verbindbar sind.

Das beschriebene Verfahren ist insbesondere dazu geeignet, einen Kapazitätswert $C_E'$ einer Erdungskapazität $C_E$ eines Stromnetzes 1 bei angeschlossener Isolationsüberwachungseinrichtung 8 zu ermitteln, ohne dass tiefgreifende Änderungen oder Umbauarbeiten am Stromnetz 1 oder der Isolationsüberwachungseinrichtung 8 vorgenommen werden müssen. Das Verfahren wird vorzugweise von einer an das Stromnetz 1 angeschlossenen Vorrichtung 16 ausgeführt. Die Vorrichtung 16 verfügt in der dargestellten Ausführungsform über ein Gehäuse 17, innerhalb dessen die Messkapazität $C_M$ sowie die Messeinrichtung 14 angeordnet ist. Die Vorrichtung 16 weist zumindest zwei elektrische Anschlüsse 18 zum elektrischen Anschluss an das Stromnetz 1 und einen Erdungsanschluss 19 zur Verbindung mit der Erde 4 auf. Die Teilmesskapazitäten $C_{M1}$ und $C_{M2}$ sind mit dem Erdungsanschluss 19 elektrisch verbunden und können über die Schalter 13 elektrisch mit den Anschlüssen 18 verbunden werden. Dadurch können die Teilmesskapazitäten $C_{M1}$ und $C_{M2}$ mit den Leitern 6 des Stromnetzes verbunden werden. Die Spannungsmesseinrichtungen 15 der Messeinrichtung 14 sind ebenfalls jeweils mit dem Erdungsanschluss 19 und mit einem der Anschlüsse 18 elektrisch verbunden. Zur Ausführung des beschriebenen Verfahrens ist eine Berechnungseinheit 20 vorgesehen, die innerhalb des Gehäuses 17 angeordnet sein kann. Alternativ kann die Berechnungseinheit 20 auch außerhalb des Gehäuses 17 angeordnet sein. Die Berechnungseinheit 20 ist dazu eingerichtet, im elektrisch an das Stromnetz 1 angeschlossenen Zustand die Periodendauer T oder eine dazu proportionale zeitliche Größe $\sim$T wie oben beschrieben zu ermitteln, beispielsweise mit Hilfe der Messeinrichtung 14, und den Kapazitätswert $C_E'$ der Erdungskapazität $C_E$ auf Basis einer sich in Folge einer Zuschaltung der Messkapazität $C_M$ an das Stromnetz 1 einstellenden Änderung der Periodendauer T oder der dazu proportionalen Größe $\sim$T zu ermitteln.

**Patentansprüche**

1. Verfahren zur Bestimmung eines Kapazitätswerts ($C_E'$) einer Erdungskapazität ($C_E$) eines ungeerdeten Stromnetzes (1), bei dem zur Überwachung eines Isolationswiderstandes ($R_E$) des Stromnetzes (1) mit Hilfe einer Isolationsüberwachungseinrichtung (8) eine periodische Spannung (10) mit einer variablen, von der Erdungskapazität ($C_E$) abhängigen Periodendauer (T) an das Stromnetz (1) aufgeschaltet wird, **dadurch gekennzeichnet, dass** eine Messkapazität ($C_M$) mit einem bekannten Kapazitätswert ($C_M'$) an das Stromnetz (1) elektrisch zugeschaltet wird und der Kapazitätswert ($C_E'$) der Erdungskapazität ($C_E$) auf Basis einer sich in Folge der Zuschaltung der Messkapazität ($C_M$) einstellenden Änderung der Periodendauer (T) oder einer dazu proportionalen zeitlichen Größe ($\sim$T) ermittelt wird.

2. Verfahren nach Anspruch 1, **dadurch gekennzeichnet, dass** zumindest eine elektrische Messeinrichtung (14), insbesondere eine Spannungsmesseinrichtung (15) elektrisch parallel zur Messkapazität ($C_M$), elektrisch an das Stromnetz (1) angeschlossen ist und auf Basis eines durch die Messeinrichtung (14) gemessenen Verlaufs einer elektrischen Größe, insbesondere eines gemessenen Spannungsverlaufs (u(t)), die Periodendauer (T) oder die dazu proportionale zeitliche Größe ($\sim$T) ermittelt wird.

3. Verfahren nach Anspruch 1 oder 2, **dadurch gekennzeichnet, dass** das Verfahren zumindest die folgenden Schritte aufweist:

    - Bestimmen einer ersten Periodendauer $T_1$ oder einer dazu proportionalen ersten zeitlichen Größe ($\sim T_1$);
    - Elektrisches Zuschalten der Messkapazität ($C_M$) an das Stromnetz (1) ;
    - Bestimmen einer zweiten Periodendauer $T_2$ oder einer dazu proportionalen zweiten zeitlichen Größe ($\sim T_2$) nach dem Zuschalten der Messkapazität ($C_M$);
    - Ermitteln des Kapazitätswerts ($C_E'$) der Erdungskapazität ($C_E$) auf Basis der ersten ($T_1$) und zweiten Periodendauer ($T_2$) oder der ersten ($\sim T_1$) und zweiten zeitlichen Größe ($\sim T_2$) .

4. Verfahren nach Anspruch 3, **dadurch gekennzeichnet, dass** der Kapazitätswert ($C_E'$) der Erdungskapazität ($C_E$) gemäß der Berechnungsvorschrift

$$C_E' = \frac{X_1}{X_2 - X_1} C_M'$$

berechnet wird, wobei $X_1$ der ersten Periodendauer ($T_1$) und $X_2$ der zweiten Periodendauer ($T_2$) oder $X_1$ der zur ersten Periodendauer ($T_1$) proportionalen ersten zeitlichen Größe ($\sim T_1$) und $X_2$ der zur zweiten Periodendauer ($T_2$) proportionalen zweiten zeitlichen Größe ($\sim T_2$) entspricht.

5. Verfahren nach einem der Ansprüche 1 bis 4, **dadurch gekennzeichnet, dass** die Messkapazität ($C_M$) zumindest zwei Teilmesskapazitäten ($C_{M1}$, $C_{M2}$) mit vorzugsweise jeweils im Wesentlichen gleich großen Kapazitätswerten ($C_{M1}'$, $C_{M2}'$) aufweist, wobei an zumindest zwei, vorzugsweise an jeden Leiter (6) des Stromnetzes (1) jeweils eine Teilmesskapazität ($C_{M1}$, $C_{M2}$) elektrisch zugeschaltet wird.

6. Vorrichtung (16) zur Bestimmung eines Kapazitätswerts ($C_E'$) einer Erdungskapazität ($C_E$) eines ungeerdeten Stromnetzes (1), an welches eine Isolationsüberwachungseinrichtung (8) angeschlossen ist, die dazu eingerichtet ist, zur Überwachung eines Isolationswiderstandes ($R_E$) des Stromnetzes (1) eine periodische Spannung (10) mit einer variablen, unter anderem von der Erdungskapazität ($C_E$) abhängigen Periodendauer (T) an das Stromnetz (1) zu schalten, wobei die Vorrichtung (16) eine Messkapazität ($C_M$) mit einem bekannten Kapazitätswert ($C_M'$) aufweist, **gekennzeichnet durch**

   - eine Berechnungseinheit (20), die dazu eingerichtet ist, im elektrisch an das Stromnetz (1) angeschlossenen Zustand der Vorrichtung (16) die Periodendauer (T) oder eine dazu proportionale zeitliche Größe ($\sim T$) zu ermitteln und den Kapazitätswert ($C_E'$) der Erdungskapazität ($C_E$) auf Basis einer sich in Folge einer Zuschaltung der Messkapazität ($C_M$) an das Stromnetz (1) einstellenden Änderung der Periodendauer (T) oder der dazu proportionalen Größe ($\sim T$) zu ermitteln.

7. Vorrichtung (16) nach Anspruch 6, **dadurch gekennzeichnet, dass** die Messkapazität ($C_M$) zumindest zwei Teilmesskapazitäten ($C_{M1}$, $C_{M2}$), insbesondere Kondensatoren (40), mit vorzugsweise jeweils im Wesentlichen gleich großen Kapazitätswerten ($C_{M1}'$, $C_{M2}'$) aufweist.

8. Vorrichtung (16) nach Anspruch 7, **dadurch gekennzeichnet, dass** ein Erdungsanschluss (19) und zumindest zwei elektrische Anschlüsse (18) zur elektrischen Verbindung mit dem Stromnetz (1) vorgesehen sind, wobei mit jedem Anschluss (18) jeweils eine Teilmesskapazität ($C_{M1}$, $C_{M2}$), vorzugsweise über einen Schalter (13), elektrisch verbindbar ist.

9. Vorrichtung (16) nach einem der Ansprüche 6 bis 8, **dadurch gekennzeichnet, dass** zumindest eine elektrische Messeinrichtung (14), insbesondere eine Spannungsmesseinrichtung (15) elektrisch parallel zur Messkapazität ($C_M$), vorgesehen ist und die Berechnungseinheit (20) dazu eingerichtet ist, auf Basis eines Verlaufs einer gemessenen elektrischen Größe, insbesondere eines gemessenen Spannungsverlaufs (u(t)), die Periodendauer (T) oder die dazu proportionale zeitliche Größe ($\sim T$) zu ermitteln.

10. System (8), aufweisend:

   - ein ungeerdetes Stromnetz (1), insbesondere eine elektrische Ladestation für ein Elektrofahrzeug oder ein Batterienetz eines Fahrzeugs, wobei das Stromnetz (1) eine Erdungskapazität ($C_E$) und einen Isolationswiderstand ($R_E$) aufweist;
   - eine an das Stromnetz (1) elektrisch angeschlossenen Isolationsüberwachungseinrichtung (8), die dazu eingerichtet ist, zur Überwachung des Isolationswiderstandes ($R_E$) des Stromnetzes (1) eine periodische Spannung (10) mit einer variablen, von der Erdungskapazität ($C_E$) abhängigen Periodendauer (T) an das Stromnetz (1) zu schalten;
   - eine Vorrichtung (16) nach einem der Ansprüche 6 bis 9, welche an das Stromnetz (1) elektrisch anschließbar ist.

## Claims

1. Method for determining a capacitance value ($C_E'$) of an earthing capacitor ($C_E$) of an unearthed power supply (1), in which method, in order to monitor an insulating resistor ($R_E$) of the power supply (1), a periodic voltage (10) having a variable period duration (T) which is dependent on the earthing capacitor ($C_E$) is superimposed onto the power supply (1) with the aid of an insulation monitoring device (8), **characterised in that** a measurement capacitor ($C_M$) having a known capacitance value ($C_M'$) is electrically connected to the power supply (1) and the capacitance value ($C_E'$) of the earthing capacitor ($C_E$) is determined on the basis of a change in the period duration (T), which occurs as a result of the connection of the measurement capacitor ($C_M$), or a variable (~T) over time which is proportional thereto.

2. Method according to claim 1, **characterised in that** at least one electrical measuring device (14), in particular a voltage measuring device (15), is electrically connected to the power supply (1) in parallel with the measurement capacitor ($C_M$), and the period duration (T) or the variable (~T) over time proportional thereto is determined on the basis of a curve of an electrical variable measured by the measuring device (14), in particular a measured voltage curve (u(t)).

3. Method according to claim 1 or 2, **characterised in that** the method comprises at least the following steps:

   - determining a first period duration $T_1$ or a first variable (~$T_1$) over time proportional thereto;
   - electrically connecting the measurement capacitor ($C_M$) to the power supply (1);
   - determining a second period duration $T_2$ or a second variable (~$T_2$) over time proportional thereto after the measurement capacitor ($C_M$) has been connected;
   - determining the capacitance value ($C_E'$) of the earthing capacitor ($C_E$) on the basis of the first ($T_1$) and second period duration ($T_2$) or the first (~$T_1$) and second variable (~$T_2$) over time.

4. Method according to claim 3, **characterised in that** the capacitance value ($C_E'$) of the earthing capacitor ($C_E$) is calculated according to the calculation rule

$$C_E' = \frac{X_1}{X_2 - X_1} C_M'$$

where $X_1$ corresponds to the first period duration ($T_1$) and $X_2$ corresponds to the second period duration ($T_2$) or $X_1$ corresponds to the first variable (-$T_1$) over time proportional to the first period duration ($T_1$) and $X_2$ corresponds to the second variable (~$T_2$) over time proportional to the second period duration ($T_2$).

5. Method according to any of claims 1 to 4, **characterised in that** the measurement capacitor ($C_M$) has at least two partial measurement capacitors ($C_{M1}$, $C_{M2}$), each preferably having substantially equal capacitance values ($C_{M1}'$, $C_{M2}'$), wherein one partial measurement capacitor ($C_{M1}$, $C_{M2}$) is electrically connected in each case to at least two, preferably to each conductor (6) of the power supply (1).

6. Device (16) for determining a capacitance value ($C_E'$) of an earthing capacitor ($C_E$) of an unearthed power supply (1), to which an insulation monitoring device (8) is connected, which, in order to monitor an insulating resistor ($R_E$) of the power supply (1), is configured to switch a periodic voltage (10), having a variable period duration (T) dependent inter alia on the earthing capacitance (CE), to the power supply (1), wherein the device (16) has a measurement capacitor ($C_M$) having a known capacitance value ($C_M'$), **characterised by**

   - a calculation unit (20) which is configured to determine the period duration (T) or a variable (~T) over time proportional thereto in the state of the device (16) in which it is electrically connected to the power supply (1) and to determine the capacitance value ($C_E'$) of the earthing capacitor ($C_E$) on the basis of a change in the period duration (T) or the variable (~T) proportional thereto which occurs as a result of the measurement capacitor ($C_M$) being connected to the power supply (1).

7. Device (16) according to claim 6, **characterised in that** the measurement capacitor ($C_M$) has at least two partial measurement capacitors ($C_{M1}$, $C_{M2}$), in particular electric capacitors (40), each preferably having substantially equal capacitance values ($C_{M1}'$, $C_{M2}'$).

8. Device (16) according to claim 7, **characterised in that** an earthing connector (19) and at least two electrical connectors (18) are provided for electrical connection to the power supply (1), wherein a partial measurement capacitor ($C_{M1}$, $C_{M2}$) can be electrically connected to each connector (18), preferably via a switch (13).

9. Device (16) according to any of claims 6 to 8, **characterised in that** at least one electrical measuring device (14), in particular a voltage measuring device (15), is provided electrically in parallel with the measurement capacitor ($C_M$) and the calculation unit (20) is configured to determine the period duration (T) or the variable (~T) over time proportional thereto on the basis of a curve of a measured electrical variable, in particular a measured voltage curve (u(t)).

**10.** System comprising:

- an unearthed power supply (1), in particular an electrical charging station for an electric vehicle or a battery network of a vehicle, wherein the power supply (1) has an earthing capacitor ($C_E$) and an insulating resistor ($R_E$);
- an insulation monitoring device (8) electrically connected to the power supply (1), which, in order to monitor the insulating resistor ($R_E$) of the power supply (1), is configured to switch a periodic voltage (10), having a variable period duration (T) dependent on the earthing capacitor ($C_E$), to the power supply (1);
- a device (16) according to any of claims 6 to 9, which can be electrically connected to the power supply (1).

## Revendications

**1.** Procédé de détermination d'une valeur de capacité ($C_E$') d'une capacité de mise à la terre ($C_E$) d'un réseau électrique (1) non mis à la terre, dans lequel pour la surveillance d'une résistance d'isolement ($R_E$) du réseau électrique (1) une tension (10) périodique avec une durée de période (T) variable et fonction de la capacité de mise à la terre ($C_E$) est mise en ligne au niveau du réseau électrique (1) à l'aide d'un équipement de surveillance d'isolement (8), **caractérisé en ce qu'**une capacité de mesure ($C_M$) est raccordée électriquement au réseau électrique (1) avec une valeur de capacité ($C_M$') connue et la valeur de capacité ($C_E$') de la capacité de mise à la terre ($C_E$) est établie sur la base d'une modification, se réglant à la suite du raccordement de la capacité de mesure ($C_M$), de la durée de période (T) ou d'une grandeur temporelle (~T) proportionnelle à celle-ci.

**2.** Procédé selon la revendication 1, **caractérisé en ce qu'**au moins un équipement de mesure (14) électrique, en particulier un équipement de mesure de tension (15) électriquement parallèle à la capacité de mesure ($C_M$), est branché électriquement au réseau électrique (1) et la durée de période (T) ou la grandeur temporelle (~T) proportionnelle à celle-ci est établie sur la base d'un tracé d'une grandeur électrique mesuré par l'équipement de mesure (14), en particulier d'un tracé de tension (u(t)) mesuré.

**3.** Procédé selon la revendication 1 ou 2, **caractérisé en ce que** le procédé présente au moins les étapes suivantes :

- détermination d'une première durée de période ($T_1$) ou d'une première grandeur temporelle (~$T_1$) proportionnelle à celle-ci ;
- raccordement électrique de la capacité de mesure ($C_M$) au réseau électrique (1) ;
- détermination d'une deuxième durée de période ($T_2$) ou d'une deuxième grandeur temporelle (~$T_2$) proportionnelle à celle-ci après le raccordement électrique de la capacité de mesure ($C_M$) ;
- établissement de la valeur de capacité ($C_E$') de la capacité de mise à la terre ($C_E$) sur la base de la première ($T_1$) et de la deuxième durée de période ($T_2$) ou de la première (~$T_1$) et de la deuxième grandeur temporelle (~$T_2$).

**4.** Procédé selon la revendication 3, **caractérisé en ce que** la valeur de capacité ($C_E$') de la capacité de mise à la terre ($C_E$) est calculée conformément à la règle de calcul

$$C_E' = \frac{X_1}{X_2 - X_1} C_M'$$

où $X_1$ correspond à la première durée de période ($T_1$) et $X_2$ à la deuxième durée de période ($T_2$) ou $X_1$ correspond à la première grandeur temporelle (~$T_1$) proportionnelle à la première durée de période ($T_1$) et $X_2$ à la deuxième grandeur temporelle (~$T_2$) proportionnelle à la deuxième durée de période ($T_2$).

**5.** Procédé selon l'une des revendications 1 à 4, **caractérisé en ce que** la capacité de mesure ($C_M$) présente au moins deux capacités de mesure partielles ($C_{M1}$, $C_{M2}$) avec de préférence respectivement des valeurs de capacité ($C_{M1}$', $C_{M2}$') sensiblement égales, dans lequel au niveau d'au moins deux conducteurs (6), de préférence de chaque conducteur, du réseau électrique (1) une capacité de mesure partielle ($C_{M1}$, $C_{M2}$) est respectivement raccordée électriquement.

**6.** Dispositif (16) de détermination d'une valeur de capacité ($C_E'$) d'une capacité de mise à la terre ($C_E$) d'un réseau électrique (1) non mis à la terre auquel est branché un équipement de surveillance d'isolement (8) qui est aménagé, pour la surveillance d'une résistance d'isolement ($R_E$) du réseau électrique (1), pour raccorder au réseau électrique (1) une tension (10) périodique avec une durée de période (T) variable et fonction entre autres de la capacité de mise à la terre ($C_E$), dans lequel le dispositif (16) présente une capacité de mesure ($C_M$) avec une valeur de capacité ($C_M'$) connue, **caractérisé par**

- une unité de calcul (20) qui est aménagée, dans un état électriquement raccordé au réseau électrique (1) du dispositif (16), pour établir la durée de période (T) ou une grandeur temporelle (~T) proportionnelle à celle-ci et établir la valeur de capacité ($C_E'$) de la capacité de mise à la terre ($C_E$) sur la base d'une modification, se réglant à la suite d'un raccordement de la capacité de mesure ($C_M$) au réseau électrique (1), de la durée de période (T) ou de la grandeur temporelle (~T) proportionnelle à celle-ci.

**7.** Dispositif (16) selon la revendication 6, **caractérisé en ce que** la capacité de mesure ($C_M$) présente au moins deux capacités de mesure partielles ($C_{M1}$, $C_{M2}$), en particulier des condensateurs (40), avec de préférence respectivement des valeurs de capacité ($C_{M1}'$, $C_{M2}'$) sensiblement égales.

**8.** Dispositif (16) selon la revendication 7, **caractérisé en ce qu'**une borne de mise à la terre (19) et au moins deux bornes électriques (18) sont prévues pour la liaison électrique avec le réseau électrique (1), dans lequel à chaque borne (18) peut être respectivement reliée électriquement, de préférence via un commutateur (13), une capacité de mesure partielle ($C_{M1}$, $C_{M2}$).

**9.** Dispositif (16) selon l'une des revendications 6 à 8, **caractérisé en ce qu'**est prévu au moins un équipement de mesure (14) électrique, en particulier un équipement de mesure de tension (15) électriquement parallèle à la capacité de mesure ($C_M$), et l'unité de calcul (20) est aménagée pour établir la durée de période (T) ou la grandeur temporelle (~T) proportionnelle à celle-ci sur la base d'un tracé d'une grandeur électrique mesurée, en particulier d'un tracé de tension (u(t)) mesuré.

**10.** Système, présentant :

- un réseau électrique (1) non mis à la terre, en particulier une station de charge électrique pour un véhicule électrique ou un réseau de batteries d'un véhicule, dans lequel le réseau électrique (1) présente une capacité de mise à la terre ($C_E$) et une résistance d'isolement ($R_E$) ;
- un équipement de surveillance d'isolement (8) raccordé électriquement au réseau électrique (1), qui est aménagé, pour la surveillance de la résistance d'isolement ($R_E$) du réseau électrique (1), pour commuter au réseau électrique (1) une tension (10) périodique avec une durée de période (T) variable et fonction de la capacité de mise à la terre ($C_E$) ;
- un dispositif (16) selon l'une des revendications 6 à 9, lequel peut être relié électriquement au réseau électrique (1).

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0654673 B1
- WO 2011160881 A1
- EP 3579002 A1
- DE 102018117296 A1
- EP 2256506 B1
- DE 2618303 A1
- DE 2357081 A1
- DE 102012019094 A1
- EP 1586910 A1